(19) Europäisches Patentamt / European Patent Office / Office européen des brevets

(11) **EP 4 174 568 A1**

(12) **EUROPEAN PATENT APPLICATION**

(43) Date of publication:
**03.05.2023  Bulletin 2023/18**

(21) Application number: **21205790.5**

(22) Date of filing: **01.11.2021**

(51) International Patent Classification (IPC):
**G02F 1/365** (2006.01)     **G02B 6/02** (2006.01)

(52) Cooperative Patent Classification (CPC):
**G02F 1/365; G03F 7/70616; G03F 9/7065;**
G02B 6/02314; G02B 6/02328; G02F 1/3528

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **BAUERSCHMIDT, Sebastian, Thomas
5500 AH Veldhoven (NL)**
• **GÖTZ, Peter, Maximilian
5500 AH Veldhoven (NL)**
• **UEBEL, Patrick, Sebastian
5500 AH Veldhoven (NL)**

(74) Representative: **ASML Netherlands B.V.
Corporate Intellectual Property
P.O. Box 324
5500 AH Veldhoven (NL)**

(54) **HOLLOW-CORE PHOTONIC CRYSTAL FIBER BASED BROADBAND RADIATION GENERATOR**

(57) A source control arrangement for a radiation source comprising a hollow-core photonic crystal fiber (HC-PCF) having a hollow core with a core diameter, comprising: at least one processor; and a pulse chirping arrangement configured to receive pulsed pump radiation and controllably chirp the pulsed pump radiation so as to output chirped pulsed pump radiation for exciting a working medium comprised within the hollow core of the fiber at a pressure. The at least one processor is operable to configure source parameters of the radiation source, which include one or both of the pressure and a pulse chirp parameter, such that the chirped pulsed pump radiation undergoes a spectral broadening process within the HC-PCF, thereby generating an output radiation having a predefined spectrum for a reference core diameter of the HC-PCF, so as to compensate for variation in the core diameter with respect to the reference core diameter.

**Fig. 10**

**Description**

FIELD

The present invention relates to a hollow-core photonic crystal fiber based broadband radiation generator, and in particular such a broadband radiation generator in relation to metrology applications in the manufacture of integrated circuits.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure, leveling tools to measure a surface topology of the substrate, for e.g., focus control and scatterometry based tools for inspecting/measuring the exposed and/or etched product in process control. In each case, a radiation source is required. For various reasons, including measurement robustness and accuracy, broadband or white light radiation sources are increasingly used for such metrology applications. It would be desirable to improve on present devices for broadband radiation generation.

SUMMARY

In a first aspect of the invention there is provided a source control arrangement for a radiation source comprising a hollow-core photonic crystal fiber (HC-PCF), the hollow-core photonic crystal fiber (HC-PCF) comprising a hollow core with a core diameter, the source control arrangement comprising: at least one processor; and a pulse chirping arrangement configured to controllably chirp the pulsed pump radiation so as to output chirped pulsed pump radiation for exciting a working medium comprised within the hollow core of the fiber at a pressure; wherein said at least one processor is operable to configure source parameters of the radiation source, said source parameters including one or both of said pressure and a pulse chirp parameter, such that the chirped pulsed pump radiation undergoes a spectral broadening process within the HC-PCF, thereby generating an output radiation having a predefined spectrum for a reference core diameter of said HC-PCF, so as to compensate for variation in said core diameter with respect to the reference core diameter.

In a second aspect of the invention there is provided a method of controlling a radiation source comprising a hollow-core photonic crystal fiber (HC-PCF), the hollow-core photonic crystal fiber (HC-PCF) comprising a hollow core with a core diameter, the method comprising: controllably chirping the pulsed pump radiation so as to output chirped pulsed pump radiation for exciting a working medium comprised within the hollow core of the fiber at a pressure; and configuring source parameters of the radiation source, said source parameters including one or both of said pressure and a pulse chirp parameter, such that the chirped pulsed pump radiation undergoes a spectral broadening process within the HC-PCF, thereby generating an output radiation having a predefined spectrum for a reference core diameter of said HC-PCF, so as to compensate for variation in said core diameter with respect to the reference core diameter.

Other aspects of the invention comprise metrology device comprising the broadband light source device of the first aspect.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a radiation source according to embodiments of the invention;
- Figure 5 depicts a schematic overview of a level sensor apparatus which may comprise a radiation source according to embodiments of the invention;
- Figure 6 depicts a schematic overview of an alignment sensor apparatus which may comprise a radiation source according to embodiments of the invention;
- Figure 7 is a schematic cross sectional view of a hollow core optical fiber that may form part of a radiation source according to an embodiment in a transverse plane (i.e. perpendicular to an axis of the optical fiber);
- Figure 8 depicts a schematic representation of a radiation source according to an embodiment for providing broadband output radiation;
- Figures 9 (a) and (b) schematically depict the transverse cross-sections of examples of hollow core photonic crystal fiber (HC-PCF) designs for supercontinuum generation;
- Figure 10 depicts a schematic representation of a radiation source (e.g., as shown in Figure 8) additionally equipped with a pulse-chirp control unit in accordance with an embodiment;
- Figure 11 is a plot of point spread power spectral density (PSD) against wavelength $\lambda$ describing a different simulation of three spectra of the broadband output radiation which compare the effectiveness of the existing method and the proposed method; and
- Figure 12 depicts a block diagram of a computer system for controlling a broadband radiation source.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

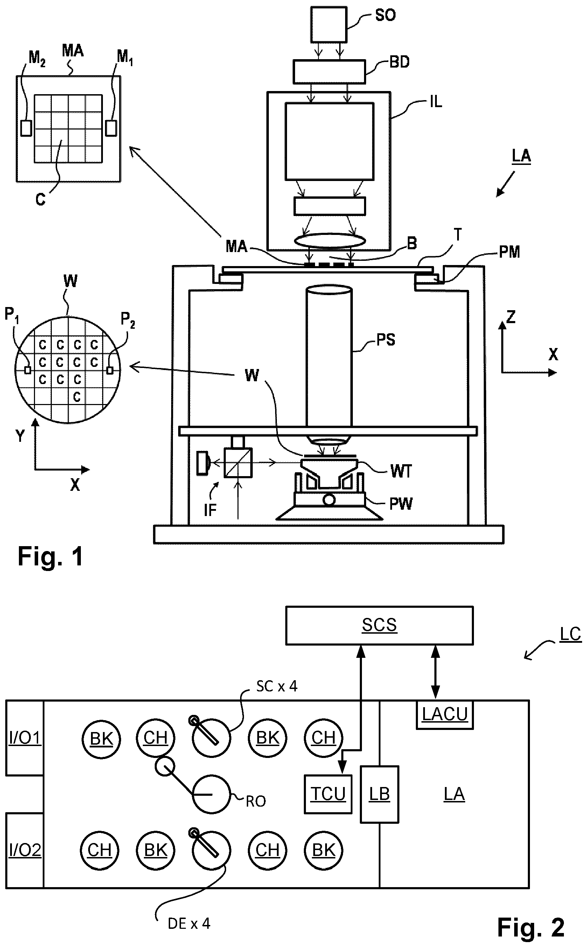

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

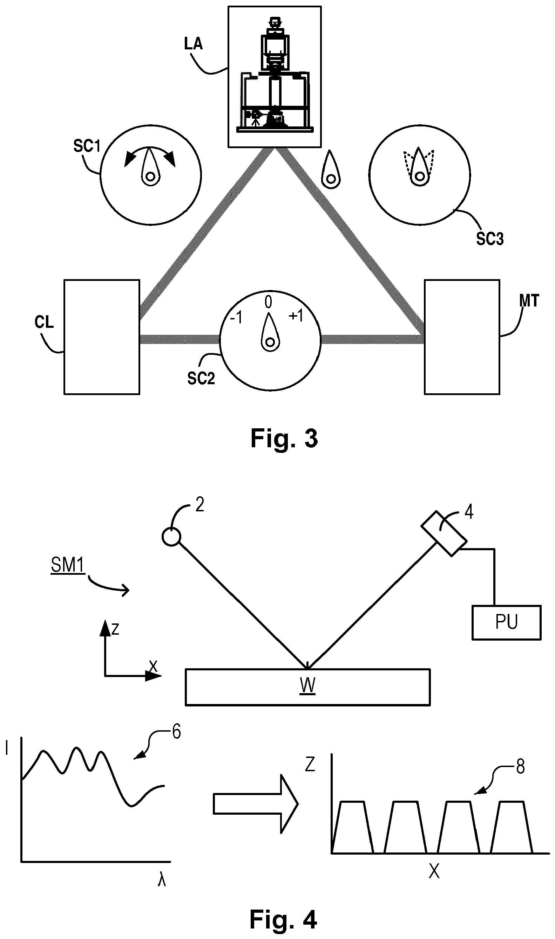

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016/0161863 and published US patent application US 2016/0370717A1 incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

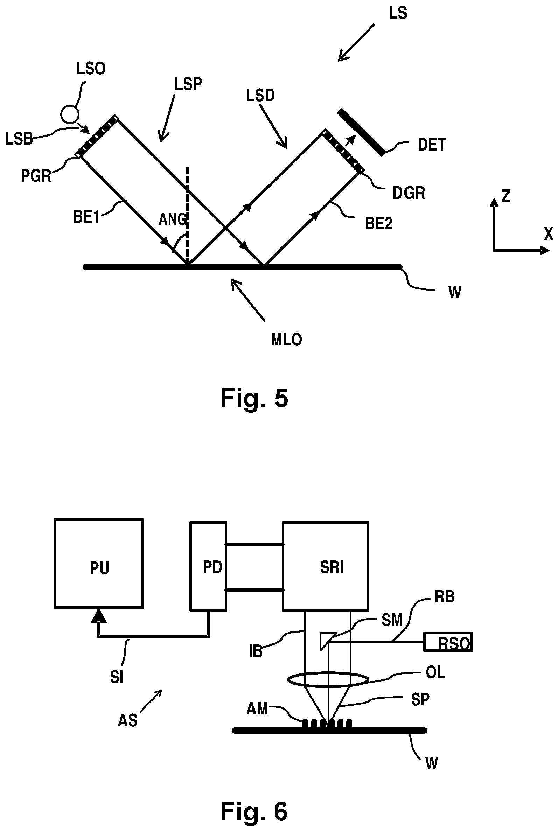

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and demultiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

High quality broadband radiation, for example supercontinuum radiation, may be difficult to generate. One method for generating broadband radiation may be to broaden high-power narrow band or single frequency input radiation or pump radiation, for example making use of non-linear, higher order effects. The input radiation (which may be produced using a laser) may be referred to as pump radiation. Alternatively, the input radiation may be referred to as seed radiation. To obtain high power radiation for broadening effects, radiation may be confined into a small area so that strongly localised high intensity radiation is achieved. In those areas, the radiation may interact with broadening structures and/or materials forming a non-linear medium so as to create broadband output radiation. In the high intensity radiation areas, different materials and/or structures may be used to enable and/or improve radiation broadening by providing a suitable non-linear medium.

In some implementations, the broadband output radiation is created in a photonic crystal fiber (PCF). In several embodiments, such a photonic crystal fiber has microstructures around its fiber core assisting in confining radiation that travels through the fiber in the fiber core. The fiber core can be made of a solid material that has non-linear properties and that is capable of generating broadband radiation when high intensity pump radiation is transmitted through the fiber core. Although it is feasible to generate broadband radiation in solid core photonic crystal fibers, there may be a few disadvantages of using a solid material. For example, if UV radiation is generated in the solid core, this radiation might not be present in the output spectrum of the fiber because the radiation is absorbed by most solid material.

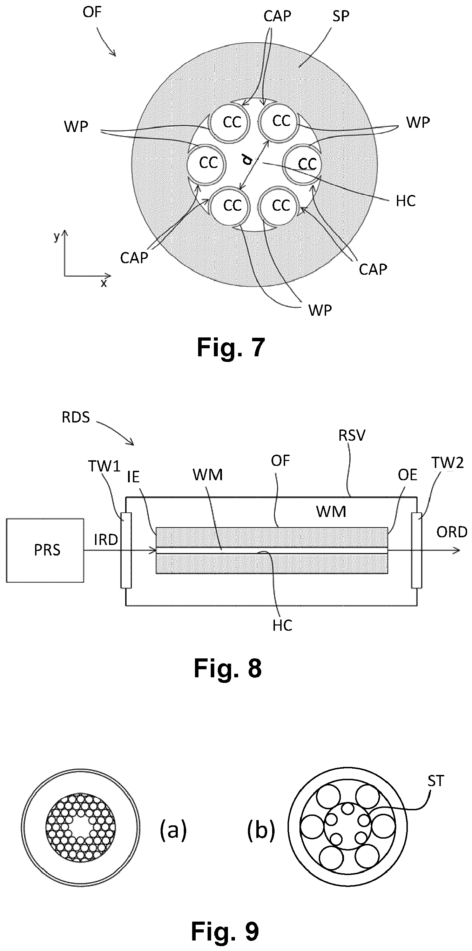

In some implementations, as discussed further below with reference to Figure 8, methods and apparatus for broadening input radiation may use a fiber for confining input radiation, and for broadening the input radiation to output broadband radiation. The fiber may be a hollow core fiber, and may comprise internal structures to achieve effective guiding and confinement of radiation in the fiber. The fiber may be a hollow core photonic crystal fiber (HC-PCF), which is particularly suitable for strong radiation confinement, predominantly inside the hollow core of the fiber, achieving high radiation intensities. The hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light.

Some embodiments relate to a new design of such a broadband radiation source comprising an optical fiber. The optical fiber is a hollow-core, photonic crystal fiber (HC-PCF). In particular, the optical fiber may be a hollow-core, photonic crystal fiber of a type comprising anti-resonant structures for confinement of radiation. Such fibers comprising anti-resonant structures are known in the art as anti-resonant fibers, tubular fibers, single-ring fibers, negative curvature fibers or inhibited coupling fibers. Various different designs of such fibers are known in the art. Alternatively, the optical fiber may be photonic bandgap fibers (HC-PBFs, for example a Kagome fiber).

A number of types of HC-PCFs can be engineered, each based on a different physical guidance mechanism. Two such HC-PCFs include: hollow-core photonic bandgap fibers (HC-PBFs) and hollow-core anti-resonant reflecting fibers (HC-ARFs). Detail on the design and manufacture of HC-PCFs can be found in US patent US2004/015085A1 (for HC-PBFs) and International PCT patent application WO2017/032454A1 (for Hollow Core anti-resonant reflecting fibers), which are incorporated herein by reference. Figure 9(a) shows a Kagome fiber, comprising a Kagome lattice structure.

An example of an optical fiber for use in the radiation source is now described with reference to Figure 7, which is a schematic cross sectional view of the optical fiber OF in a transverse plane. Further embodiments similar to the practical example of the fiber of Figure 7 are disclosed in WO2017/032454A1.

The optical fiber OF comprises an elongate body, which is longer in one dimension compared to the other two dimensions of the fiber OF. This longer dimension may be referred to as an axial direction and may define an axis of the optical fiber OF. The two other dimensions define a plane which may be referred to as a transverse plane. Figure 7 shows a cross-section of the optical fiber OF in this transverse plane (i.e. perpendicular to the axis), which is labelled as the x-y plane. The transverse cross-section of the optical fiber OF may be substantially constant along the fiber axis.

It will be appreciated that the optical fiber OF has some degree of flexibility and therefore the direction of the axis will not, in general, be uniform along the length of the optical fiber OF. The terms such as the optical axis, the transverse cross-section and the like will be understood to mean the local optical axis, the local transverse cross-section and so on. Furthermore, where components are described as being cylindrical or tubular these terms will be understood to encompass such shapes that may have been distorted as the optical fiber OF is flexed.

The optical fiber OF may have any length and it will be appreciated that the length of the optical fiber OF may be dependent on the application. The optical fiber OF may have a length between 1 cm and 10 m, for example, the optical fiber OF may have a length between 10 cm and 100 cm.

The optical fiber OF comprises: a hollow core HC; a cladding portion surrounding the hollow core HC; and a support portion SP surrounding and supporting the cladding portion. The optical fiber OF may be considered to comprise a body (comprising the cladding portion and the support portion SP) having a hollow core HC. The cladding portion comprises a plurality of anti-resonance elements for guiding radiation through the hollow core HC. In particular, the plurality of anti-resonance elements are arranged to confine radiation that propagates through the optical fiber OF predominantly inside the hollow core HC and to guide the radiation along the optical fiber OF. The hollow core HC of the optical fiber OF may be disposed substantially in a central region of the optical fiber OF, so that the axis of the optical fiber OF may also define an axis of the hollow core HC of the optical fiber OF.

The cladding portion comprises a plurality of anti-resonance elements for guiding radiation propagating through the optical fiber OF. In particular, in this embodiment, the cladding portion comprises a single ring of six tubular capillaries CAP. Each of the tubular capillaries CAP acts as an anti-resonance element.

The capillaries CAP may also be referred to as tubes. The capillaries CAP may be circular in cross section, or may have another shape. Each capillary CAP comprises a generally cylindrical wall portion WP that at least partially defines the hollow core HC of the optical fiber OF and separates the hollow core HC from a capillary cavity CC. It will be appreciated that the wall portion WP may act as an anti-reflecting Fabry-Perot resonator for radiation that propagates through the hollow core HC (and which may be incident on the wall portion WP at a grazing incidence angle). The thickness of the wall portion WP may be suitable so as to ensure that reflection back into the hollow core HC is generally enhanced whereas transmission into the capillary cavity CC is generally suppressed. In some embodiments, the capillary wall portion WP may have a thickness between 0.01 - 10.0 $\mu$m.

It will be appreciated that, as used herein, the term cladding portion is intended to mean a portion of the optical fiber OF for guiding radiation propagating through the optical fiber OF (i.e. the capillaries CAP which confine said radiation within the hollow core HC). The radiation may be confined in the form of transverse modes, propagating along the fiber axis.

The support portion is generally tubular and supports the six capillaries CAP of the cladding portion. The six capillaries CAP are distributed evenly around an inner surface if the inner support portion SP. The six capillaries CAP may be described as being disposed in a generally hexagonal formation.

The capillaries CAP are arranged so that each capillary is not in contact with any of the other capillaries CAP. Each of the capillaries CAP is in contact with the inner support portion SP and spaced apart from adjacent capillaries CAP in the ring structure. Such an arrangement may be beneficial since it may increase a transmission bandwidth of the optical fiber OF (relative, for example, to an arrangement wherein the capillaries are in contact with each other). Alternatively, in some embodiments, each of the capillaries CAP may be in contact with adjacent capillaries CAP in the ring structure.

The six capillaries CAP of the cladding portion are disposed in a ring structure around the hollow core HC. An inner surface of the ring structure of capillaries CAP at least partially defines the hollow core HC of the optical fiber OF. The diameter d of the hollow core HC (which may be defined as the smallest dimension between opposed capillaries, indicated by arrow d) may be between 10 and 1000 μm. The diameter d of the hollow core HC may affect the mode field diameter, impact loss, dispersion, modal plurality, and non-linearity properties of the hollow core HC optical fiber OF.

In this embodiment, the cladding portion comprises a single ring arrangement of capillaries CAP (which act as anti-resonance elements). Therefore, a line in any radial direction from a center of the hollow core HC to an exterior of the optical fiber OF passes through no more than one capillary CAP.

It will be appreciated that other embodiments may be provided with different arrangements of anti-resonance elements. These may include arrangements having multiple rings of anti-resonance elements and arrangements having nested anti-resonance elements. Figure 9(a) shows an embodiment of HC-PCFs with three rings of capillaries CAP stacking on top of each other along the radial direction. In this embodiment, each capillary CAP is in contact with other capillaries both in the same ring and in a different ring. Furthermore, although the embodiment shown in Figure 7 comprises a ring of six capillaries, in other embodiments, one or more rings comprising any number of anti-resonance elements (for example 4, 5, 6, 7, 8, 9, 10, 11 or 12 capillaries) may be provided in the cladding portion.

Figure 9(b) shows a modified embodiment of the above discussed HC-PCFs with a single ring of tubular capillaries. In the example of Figure 9(b) there are two coaxial rings of tubular capillaries 21. For holding the inner and outer rings of tubular capillaries 21, a support tube ST may be included in the HC-PCF. The support tube may be made of silica.

The tubular capillaries of the examples of Figure 7 and Figures 9 (a) and (b) may have a circular cross-sectional shape. Other shapes are also possible for the tubular capillaries, like elliptical or polygonal cross-sections. Additionally, the solid material of the tubular capillaries of the examples of Figure 7 and Figures 9 (a) and (b) may comprise plastic material, like PMA, glass, like silica, or soft glass.

Figure 8 depicts a radiation source RDS for providing broadband output radiation. The radiation source RDS comprises a pulsed pump radiation source PRS or any other type of source that is capable of generating short pulses of a desired length and energy level; an optical fiber OF (for example of the type shown in Figure 7) with a hollow core HC; and a working medium WM (for example a gas) disposed within the hollow core HC. Although in Figure 8 the radiation source RDS comprises the optical fiber OF shown in Figure 7, in alternative embodiments other types of hollow core HC optical fiber OF may be used.

The pulsed pump radiation source PRS is configured to provide input radiation IRD. The hollow core HC of the optical fiber OF is arranged to receive the input radiation IRD from the pulsed pump radiation source PRS, and broaden it to provide output radiation ORD. The working medium WM enables the broadening of the frequency range of the received input radiation IRD so as to provide broadband output radiation ORD.

The radiation source RDS further comprises a reservoir RSV. The optical fiber OF is disposed inside the reservoir RSV. The reservoir RSV may also be referred to as a housing, container or gas cell. The reservoir RSV is configured to contain the working medium WM. The reservoir RSV may comprise one or more features, known in the art, for controlling, regulating, and/or monitoring the composition of the working medium WM (which may be a gas) inside the reservoir RSV. The reservoir RSV may comprise a first transparent window TW1. In use, the optical fiber OF is disposed inside the reservoir RSV such that the first transparent window TW1 is located proximate to an input end IE of the optical fiber OF. The first transparent window TW1 may form part of a wall of the reservoir RSV. The first transparent window TW1 may be transparent for at least the received input radiation frequencies, so that received input radiation IRD (or at least a large portion thereof) may be coupled into the optical fiber OF located inside reservoir RSV. It will be appreciated that optics (not shown) may be provided for coupling the input radiation IRD into the optical fiber OF.

The reservoir RSV comprises a second transparent window TW2, forming part of a wall of the reservoir RSV. In use, when the optical fiber OF is disposed inside the reservoir RSV, the second transparent window TW2 is located proximate to an output end OE of the optical fiber OF. The second transparent window TW2 may be transparent for at least the frequencies of the broadband output radiation ORD of the apparatus 120.

Alternatively, in another embodiment, the two opposed ends of the optical fiber OF may be placed inside different reservoirs. The optical fiber OF may comprise a first end section configured to receive input radiation IRD, and a second end section for outputting broadband output radiation ORD. The first end section may be placed inside a first reservoir, comprising a working medium WM. The second end section may be placed inside a second reservoir, wherein the second reservoir may also comprise a working medium WM. The functioning of the reservoirs may be as described in relation to Figure 8 above. The first reservoir may comprise a first transparent window, configured to be transparent for input radiation IRD. The second reservoir may comprise a second transparent window configured to be transparent for broadband output broadband radiation ORD. The first and second reservoirs may also comprise a sealable opening to permit the optical fiber OF to be placed partially inside and partially outside the reservoir, so that a gas can be sealed inside the reservoir. The optical fiber OF may further comprise a middle section not contained inside a reservoir. Such an arrangement using two separate gas reservoirs may be particularly convenient for embodiments wherein the optical fiber OF is relatively long (for example when the length is more than 1 m). It will be appreciated that for such arrangements which use two separate gas reservoirs, the two reservoirs (which may comprise one or more features, known in the art, for controlling, regulating, and/or monitoring the composition of a gas inside the two reservoirs) may be considered to provide an apparatus for providing the working medium WM within the hollow core HC of the optical fiber OF.

In this context a window may be transparent for a frequency if at least 50%, 75%, 85%, 90%, 95%, or 99% of incident radiation of that frequency on the window is transmitted through the window.

Both the first TW1 and the second TW2 transparent windows may form an airtight seal within the walls of the reservoir RSV so that the working medium WM (which may be a gas) may be contained within the reservoir RSV. It will be appreciated that the gas WM may be contained within the reservoir RSV at a pressure different to the ambient pressure of the reservoir RSV.

The working medium WM may comprise a noble gas such as Argon, Krypton, and Xenon, a Raman active gas such as Hydrogen, Deuterium and Nitrogen, or a gas mixture such as an Argon/Hydrogen mixture, a Xenon/Deuterium mixture, a Krypton/Nitrogen mixture, or a Nitrogen/Hydrogen mixture. Depending on the type of filling gas, the nonlinear optical processes can include modulational instability (MI), soliton self-compression, soliton fission, Kerr effect, Raman effect and dispersive wave generation (DWG), details of which are described in WO2018/127266A1 and US9160137B1 (both of which are hereby incorporated by reference). Since the dispersion of the filling gas can be tuned by varying the working medium WM pressure in the reservoir RSR (i.e. gas cell pressure), the generated broadband pulse dynamics and the associated spectral broadening characteristics can be adjusted so as to optimize the frequency conversion

In one implementation, the working medium WM may be disposed within the hollow core HC at least during receipt of input radiation IRD for producing broadband output radiation ORD. It will be appreciated that, while the optical fiber OF is not receiving input radiation IRD for producing broadband output radiation, the gas WM may be wholly or partially absent from the hollow core HC.

In order to achieve frequency broadening high intensity radiation may be desirable. An advantage of having a hollow core HC optical fiber OF is that it may achieve high intensity radiation through strong spatial confinement of radiation propagating through the optical fiber OF, achieving high localised radiation intensities. The radiation intensity inside the optical fiber OF may be high, for example due to high received input radiation intensity and/or due to strong spatial confinement of the radiation inside the optical fiber OF. An advantage of hollow core optical fibers is that they can guide radiation having a broader wavelength range that solid-core fibers and, in particular, hollow core optical fibers can guide radiation in both the ultraviolet and infrared ranges.

An advantage of using a hollow core HC optical fiber OF may be that the majority of the radiation guided inside the optical fiber OF is confined to the hollow core HC. Therefore, the majority of the interaction of the radiation inside the optical fiber OF is with the working medium WM, which is provided inside the hollow core HC of the optical fiber OF. As a result, the broadening effects of the working medium WM on the radiation may be increased.

The received input radiation IRD may be electromagnetic radiation. The input radiation IRD may be received as pulsed radiation. For example, the input radiation IRD may comprise ultrafast pulses, for example, generated by a laser.

The input radiation IRD may be coherent radiation. The input radiation IRD may be collimated radiation, an advantage of which may be to facilitate and improve the efficiency of coupling the input radiation IRD into the optical fiber OF. The input radiation IRD may comprise a single frequency, or a narrow range of frequencies. The input radiation IRD may be generated by a laser. Similarly, the output radiation ORD may be collimated and/or may be coherent.

The broadband range of the output radiation ORD may be a continuous range, comprising a continuous range of radiation frequencies. The output radiation ORD may comprise supercontinuum radiation. Continuous radiation may be beneficial for use in a number of applications, for example in metrology applications. For example, the continuous range of frequencies may be used to interrogate a large number of properties. The continuous range of frequencies may for example be used to determine and/or eliminate a frequency dependency of a measured property. Supercontinuum output radiation ORD may comprise for example electromagnetic radiation over a wavelength range of 100 nm - 4000 nm. The broadband output radiation ORD frequency range may be for example 400 nm - 900 nm, 500 nm - 900 nm, or 200 nm - 2000 nm. The supercontinuum output radiation ORD may comprise white light.

The input radiation IRD provided by the pulsed pump radiation source PRS may be pulsed. The input radiation IRD may comprise electromagnetic radiation of one or more frequencies between 200 nm and 2 $\mu$m. The input radiation IRD may for example comprise electromagnetic radiation with a wavelength of 1.03 $\mu$m. The repetition rate of the pulsed radiation IRD may be of an order of magnitude of 1 kHz to 100 MHz. The pulse energies may have an order of magnitude of 0.1 $\mu$J to 100 $\mu$J, for example 1 - 10 $\mu$J. A pulse duration for the input radiation IRD may be between 10 fs and 10 ps, for example 300 fs. The average power of input radiation IRD may be between 100 mW to several 100 W. The average power of input radiation IRD may for example be 20 - 50 W.

The pulsed pump radiation source PRS may be a laser. The spatio-temporal transmission characteristics of such a laser pulse, e.g. its spectral amplitude and phase, transmitted along the optical fiber OF can be varied and tuned through adjustment of (pump) laser parameters, working component WM variations, and optical fiber OF parameters. Said spatio-temporal transmission characteristics may include one or more of: output power, output mode profile, output temporal profile, width of the output temporal profile (or output pulse width), output spectral profile, and bandwidth of the output spectral profile (or output spectral bandwidth). Said pulsed pump radiation source PRS parameters may include one or more of: pump wavelength, pump pulse energy, pump pulse width, pump pulse repetition rate. Said optical fiber OF parameters may include one or more of: optical fiber length, size and shape of the hollow core HC, size and shape of the capillaries, thickness of the walls of the capillaries surrounding the hollow core HC. Said working component WM, e.g. filling gas, parameters may include one or more of: gas type, gas pressure and gas temperature.

The broadband output radiation ORD provided by the radiation source RDS may have an average output power of at least 1 W. The average output power may be at least 5 W. The average output power may be at least 10 W. The broadband output radiation ORD may be pulsed broadband output radiation ORD. The broadband output radiation ORD may have a power spectral density in the entire wavelength band of the output radiation of at least 0.01 mW/nm. The power spectral density in the entire wavelength band of the broadband output radiation may be at least 3 mW/nm.

For use in a metrology sensor/tool MT, such as any of the abovementioned metrology sensors, it is desirable that the broadband output radiation ORD meets various requirements of the sensor. These may include requirements on spatial, temporal and spectral characteristics of the broadband output radiation ORD. For example, certain metrology sensors may require that variations of the power spectral density (PSD) of the broadband output radiation ORD should not exceed a maximum variation level. In other words, the PSD, either measured at one or more given wavelengths or averaged over a certain wavelength range, should be kept within a desired or specified PSD range.

The tight tolerances on the PSD variations may impose tight boundaries (or tolerance ranges) on the operating parameters of the broadband radiation source, i.e., one or more of: the pulsed pump radiation source RDS parameters (e.g., pump wavelength, pump pulse energy, pump pulse width, pump pulse repetition rate), the optical fiber OF parameters (e.g., optical fiber length, size and shape of the hollow core HC, size and shape of the capillaries), and the working medium WM, e.g. filling gas, parameters (e.g., gas type, gas pressure and gas temperature). As a consequence, when used in a metrology tool MT, the operating parameters of a radiation source RDS should be tightly controlled within their respective tolerance ranges in order to generate broadband output radiation ORD having characteristics acceptable by the metrology tool MT. A skilled person will appreciate that not all of the aforementioned operating parameters can be actively adjusted while broadband output radiation ORD is being generated. For example, optical fiber OF parameters (e.g., fiber core diameter) may not be easily changed once a HC-PCF is placed and aligned within a radiation source RDS. Hence, the impact of variations of optical fiber OF parameters (e.g., fiber core diameter variations) on the broadband output radiation ORD (e.g., broadband spectrum) may instead be compensated passively through adjustment of other operating parameters (e.g., pump parameters and/or working medium parameters).

Variations of optical fiber parameters typically result from limitations of the existing manufacturing process. For example, with the existing fiber drawing process, the fiber core diameter of a production HC-PCF may typically deviate from a reference core diameter (e.g., a target or nominal core diameter) by as much as 10% of the reference diameter. This means that, for a reference core diameter of e.g., 30 $\mu$m, the core diameter of a production fiber can vary between 27 $\mu$m and 33 $\mu$m. The inventors have performed numerical simulations to understand the impact of core diameter variations on the broadband output radiation. In the simulations, the core diameter was incrementally varied (e.g., increased from 27 $\mu$m to 33 $\mu$m with an increment of 0.5 $\mu$m) and the spectrum of the broadband output radiation ORD was monitored. When the core diameter was varied, other operating parameters were kept unchanged.

As described above, there are many nonlinear optical processes involved in generation of broadband output radiation ORD (e.g., supercontinuum or white light). Which nonlinear optical process has a more pronounced spectral broadening effect over the others will depend on how the operating parameters are set. For example, by selecting a pump wavelength and/or an optical fiber such that the pump pulse propagates through the fiber in a normal dispersion region (positive group velocity dispersion (GVD)), self-phase modulation is the dominant nonlinear optical process and is responsible for spectral expansion of the pump pulse. However in most cases, spectral broadening of input radiation IRD provided by the pulsed pump radiation source PRS is driven by soliton dynamics which require a pump pulse to propagate in an optical fiber OF in the anomalous dispersion region (negative GVD). This is because, in the anomalous dispersion region, the effects of Kerr nonlinearity and dispersion act in opposition to each other. When the pulse parameters of a pump pulse, which is launched into an optical fiber (e.g., HC-PCF) with anomalous chromatic dispersion, do not exactly match those of a soliton, the pump pulse will evolve into a soliton pulse with a certain soliton order and a dispersive wave.

It is known that soliton fission and modulation instability (MI) are the two primary mechanisms for spectral broadening in soliton driven broadband radiation generation. The distinction between the two mechanisms is that the soliton fission process is associated with low soliton orders whereas the MI process is associated with high soliton orders. MI is a physical process which refers to the spontaneous growth of spectral sidebands of a strong narrow-band (compared to the MI modulation frequency) pump pulse in a nonlinear dispersive medium. MI generally arises in the anomalous dispersion regime; however, it can also arise in the normal dispersion region if certain requirements are fulfilled, for example, high order dispersion is present. During the MI process, tiny perturbations present in the electric field (or envelope) of the pulse, e.g., due to quantum fluctuations, are amplified exponentially in the presence of Kerr nonlinearity. The amount of amplification is determined by the MI gain. During such a MI process, the temporal pulse envelope breaks into a plurality of short temporal sub-structures or fundamental solitons. In parallel to this, spectral side bands are created symmetrically at both sides of the peak pump wavelength resulting in a continuously broadening spectral profile.

The modulation frequency is expressed as:

$$\Delta\omega_{MI} = \sqrt{\frac{2\gamma P}{|\beta_2|}} \qquad\qquad \text{Eq. [1]}$$

and the corresponding MI period is given by:

$$T_{MI} = \frac{2\pi}{\Delta\omega_{MI}} = \frac{2\pi}{\sqrt{\frac{2\gamma P}{|\beta_2|}}} \qquad\qquad \text{Eq. [2]}$$

where $\gamma$ denotes nonlinear coefficient, P denotes pump power, and $\beta_2$ denotes fiber propagation constant. For the MI process to dominate, the pump pulse should be sufficiently longer than the MI period $T_{MI}$. However, it is not possible to tell from the pump pulse duration alone whether the soliton fission process or the MI process will be the dominant mechanism for spectral expansion in broadband radiation generation. This is because the pump pulse duration scales with the pump peak power which affects the nonlinear coefficient and thus the modulation period.

For a given pump pulse with a pulse duration $\tau$, the equivalent soliton order N is given by:

$$N = \frac{\sqrt{2}\pi\tau_0}{T_{MI}}. \qquad\qquad \text{Eq. [3]}$$

In Eq. [1], for $N = 1$, the soliton is the fundamental soliton. All other solitons with $N > 1$, are high order solitons. As described above, for the MI process to be the dominant spectral broadening mechanism, the pump pulse needs to be sufficiently longer than the MI period $T_{MI}$ (or $\tau_0 >> T_{MI}$). It has been found that spectral broadening is typically dominated by the MI process when $N >> 20$ whereas spectral broadening is typically dominated by soliton fission when $N << 20$. Therefore, for arrangements which use the MI process, it is desirable to produce input radiation IRD with a high soliton order $N$. Furthermore, as can be seen from Eq. [3], the soliton order of the input radiation IRD is proportional to the pulse duration $\tau_0$ of the input radiation IRD. Therefore, for typical prior art arrangements where the MI process dominates, the pulse duration $\tau_0$ of the input radiation IRD typically ranges from 100 femtoseconds (fs) to 10s of picoseconds (ps), and the pulse energy ranges from 1 microjoules ($\mu$J) to 20 $\mu$J.

Referring back to the aforementioned simulations, the equivalent soliton order N of the pump pulse is approximately 50 indicating the spectral broadening of the pump pulse is predominantly based on the MI process. The inventors have demonstrated that the core diameter variations have two main effects on the output spectrum: First, a core diameter variation changes the nominal PSD; for example, a 10 % core diameter change results in a PSD change of more than 50 % at 800 nm. Second, a core diameter variation causes a significant shift of the blue edge of the spectrum; for example, a 10 % core diameter change results in a blue edge shift of more than 50 nm. Such two effects may not be acceptable for many metrology applications.

An existing method to recover the spectral shape (e.g., the PSD and position of the blue edge) is to adjust the pump pulse energy and the gas pressure, also referred to the energy-compensation technique. The skilled person will appreciate that for a constant pulse width $T_p$, changing the pump pulse energy $E_p$ not only changes the peak power $P_p$ of each pump pulse due to their relation of $E_p = T_p \times P_p$, but also changes the average pump power $P_{ave}$ which is a product of the pump pulse energy $E_p$ and the pulse repetition rate $F_p$, i.e. $P_{ave} = E_p \times F_p$. As such, a change in the pump pulse energy results in a change in the nonlinearity (predominantly as a result of the change in the peak intensity) of the spectral broadening process (e.g., the MI process) in the gas-filled hollow core HC which in turn causes a shift of the blue edge of the spectrum, and a change in the PSD (predominantly as a result of the change in the average pump power) of the output spectrum. The skilled person will also appreciate that changing the gas pressure changes the density of the working medium WM which changes the nonlinearity of the spectral broadening process in the gas-filled hollow core HC and thus shifts the blue edge of the spectrum. To bring the PSD of any particular wavelengths or of a wavelength range back to the desired/specified PSD range, downstream optics (e.g., for power regulation) will need to be installed which increases costs and volume.

When implementing the existing method, the gas pressure is first adjusted according to the core diameter of a HC-PCF. It is known that increasing (decreasing) the fiber core diameter needs to be compensated by decreasing (increasing) the gas pressure so as to maintain substantially the same dispersion environment for the subsequent soliton evolution. Since decreasing (increasing) the fiber core diameter and increasing (decreasing) the gas pressure both increase (decrease) the nonlinearity of the spectral broadening process, therefore, the pump pulse energy needs to be decreased (increased) so as to maintain substantially the same nonlinearity for different core diameters. Table 1 lists the required gas pressure and relative pulse energy for each different core diameter. For example, in the case of the largest acceptable core diameter of 33 $\mu$m (e.g., the upper end of a manufacturing range), the gas pressure was 21 bar, and the pump pulse energy was set to a maximum value $E_{p,max}$. The maximum pump pulse energy $E_{p,max}$ may be in the range for example between 1.0 $\mu$J and 10.0 $\mu$J. Whereas, in the case where the core diameter was 27 $\mu$m and the gas pressure was 32.1 bar, the pump pulse energy was reduced from the maximum value $E_{p,max}$ to 67% $\times$ $E_{p,max}$. The inventors have learnt from simulations that the existing method is useful to some extent for compensating the negative impact of the core diameter variation. The compensating effect is reflected by the fact that the spectral shape (e.g., the blue and red edge positions) of the spectra is substantially maintained. However, despite the improvement, the PSD of the spectra still varies considerably in the range between 400 nm to 900 nm; for example, a 10 % core diameter change results in a PSD change of approximately 20 % at 800 nm.

Table 1

| Fiber core diameter ($\mu$m) | Working medium pressure (bar) | Realtive pump pulse energy (%) |
|---|---|---|
| 27 | 32.1 | 67 |
| 28 | 29.8 | 73 |
| 29 | 27.6 | 78 |
| 30 | 25.7 | 83 |
| 31 | 24.0 | 91 |
| 32 | 22.4 | 94 |
| 33 | 21.0 | 100 |

The inventors have found that the aforementioned problem inherent in the existing method is mainly caused by the fact that adjusting the pump pulse energy changes the pump average power and the pump peak power concurrently. Hence, in this disclosure, a method and apparatus is proposed which are able to compensate fiber core diameter variations without suffering from the above mentioned shortcomings.

The proposed method and apparatus which are embodied in the following examples are based on the observation that it is possible to significantly reduce the PSD variations while maintaining substantially the same spectral shape (e.g., one or both edge positions of the spectrum) by applying a (temporal) chirp to the pump pulse.

Here, the temporal chirp is understood as the time dependence of the instantaneous frequency of a laser pulse. It is known that when a short laser pulse travels through a dispersive medium, the component frequencies are separated in time. While traversing the dispersive medium, the center of the laser pulse is delayed with respect to a pulse travelling in vacuum; this is usually called the group delay (GD). In addition, the dispersive medium also imposes a frequency sweep or chirp on the pulse. Specifically, for an up-chirp, the instantaneous frequency increases linearly from the leading edge to the trailing edge of the laser pulse; whereas for a down-chirp, the instantaneous frequency decreases with time.

To better understand the effect of the chirp, it is common to consider the phase shift $\varphi(\omega)$ as a function of frequency $\omega$:

$$\varphi(\omega) = \varphi(\omega_0) + (\omega - \omega_0)\varphi'(\omega_0) + \frac{1}{2}(\omega - \omega_0)^2\varphi''(\omega_0) + \frac{1}{6}(\omega - \omega_0)^3\varphi'''(\omega_0) +$$

$$\frac{1}{24}(\omega - \omega_0)^4\varphi''''(\omega_0) + \cdots, \qquad\qquad \text{EQ. [4]}$$

where $\varphi'$ is the GD, $\varphi''$ is the group delay dispersion (GDD) or second order dispersion, $\varphi'''$ is the third order dispersion

(TOD) and $\varphi''''$ is the fourth order dispersion (FOD). For a Guassian transform limited pulse (i.e. the shortest possible pulse width for a given bandwidth) and assuming only a contribution from the GDD term, the output pulse width $\tau_{out}$ (after traversing the dispersive medium) is broadened or stretched with respect to the input pulse width $\tau_{in}$ (before entering the dispersive medium) by a factor $\gamma$:

$$\gamma = \frac{\tau_{out}}{\tau_{in}} = \sqrt{1 + \frac{\varphi''}{\tau_{in}^4} 16(ln2)^2}. \qquad \text{EQ. [5]}$$

A detailed review of pulse chirping and pulse width management is provided by: Gavin D. Reid and Klaas Wynne, "Ultrafast Laser Technology and Spectroscopy" in Encyclopedia of Analytical Chemistry, R.A. Meyers (Ed.), pp. 13644-13670, John Wiley & Sons Ltd, Chichester, 2000, which is incorporated herein by reference.

Although nonlinear chirping may also be applicable and used for the concepts disclosed herein, the embodiments described below will be described in terms of linear chirping. Note that a pulse with an up-chirp can also be described as a positively chirped pulse and a pulse with a down-chirp can also be described as a negatively chirped pulse.

The amount or magnitude of a temporal chirp (either up-chirp or down-chirp) can be characterized or quantified by an amount of GDD (in the units of seconds squared ($s^2$) or femtoseconds squared ($fs^2$)) that is required to compress the chirped pulse to the shortest pulse width. The inventors have found that it is preferable to implement the proposed method and apparatus in a HC-PCF based radiation source RDS where the spectral broadening of the input radiation IRD (or the pump pulses) is predominantly obtained through the MI process. However, this should not preclude their applications in other radiation sources where the broadband output radiation ORD is generated through a different nonlinear optical process.

Through numerical simulations, the inventors have found that at a given fiber core diameter and gas pressure, the pump pulse energy $E_p$ can be increased by the same proportion while the pump pulse $T_p$ is temporally stretched. For example, a 10% increase in the pump pulse width may allow for a 10% increase in the pump pulse energy while maintaining a substantially constant pulse peak power. The proportional changes in the pump pulse energy $Ep$ and the pump pulse width $T_p$ means the pump peak power remains unchanged because $P_p = E_p/T_p = constant$. The possibility of changing the pump pulse energy without affecting the pump peak power may allow the same pump pulse energy that is optimal for one core diameter to be used for one or more different core diameters.

By way of an example and referring back to Table 1, when an existing fiber with a core diameter of 33 $\mu$m is to be replaced with a new fiber with a smaller core diameter of 27 $\mu$m, the existing method would require the optimized pump pulse energy (i.e. the maximum pump pulse energy $E_{p,max}$) to be reduced to 67% $\times$ $E_{p,max}$, thereby resulting in the undesired impact on the output spectrum (as described above). In contrast, the embodiments disclosed herein allow the pump pulse energy to be maintained at $E_{p,max}$ even when the core diameter is reduced from 33 $\mu$m to 27 $\mu$m. This essentially means the optimal pulse energy for a core diameter of 27 $\mu$m is increased from 67% $\times$ $E_{p,max}$ to 100% $\times$ $E_{p,max}$. Here, the optimal pump pulse energy refers to the energy value which results in a broadband output spectrum closest to a target or predefined broadband spectrum. This increase of the pump pulse energy for a given core diameter is enabled by applying a suitable amount of chirp or GDD to the pump pulse so as to temporally stretch the pump pulse by the same proportion as the pump pulse energy. As such, the shape (e.g., one or both edge positions) of the broadband spectrum may remain substantially unaffected (due to the constant pump pulse width), whereas the absolute PSD level of the broadband spectrum may scale with the pump pulse energy (or equivalent the average power). The inventors have also found that the pulse width of the temporally stretched pumped pulse may remain substantially unchanged while traversing the length of the fiber for the generation of the broadband output radiation. This is particularly the case where the MI process is the dominant spectral broadening mechanism. For example, while propagating through the hollow core of the fiber, a pulse duration of the chirped pulsed pump radiation may be always broader than 75% of an initial pulse duration of the chirped pulsed pump radiation upon entering the hollow core of the fiber.

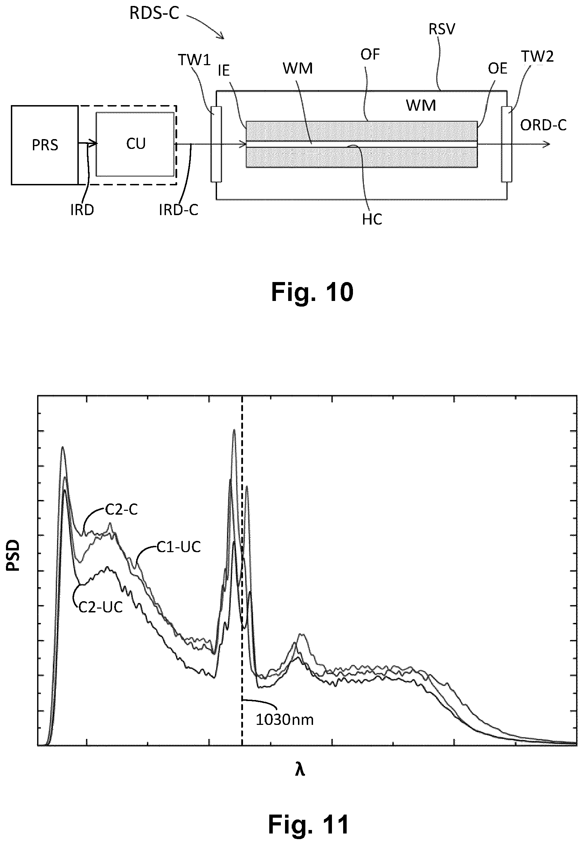

Figure 10 depicts a schematic representation of a radiation source (e.g., as shown in Figure 8) additionally equipped with a source control arrangement. The source control arrangement may comprise at least one processor (not shown- the at least one processor may comprise a processor of the radiation source or otherwise) and a pulse chirping arrangement (e.g., a pulse-chirp control unit CU) configured to receive pulsed pump radiation IRD and controllably chirp the pulsed pump radiation IRD so as to output chirped pulsed pump radiation IRD-C for exciting a working medium comprised within the hollow core of the fiber at a pressure; wherein said at least one processor is operable to configure source parameters of the radiation source, said source parameters including one or both of said pressure and a pulse chirp parameter, such that the chirped pulsed pump radiation undergoes a spectral broadening process within the HC-PCF, thereby generating an output radiation ORD having a predefined spectrum for a reference core diameter of said HC-PCF, so as to compensate for variation in said core diameter with respect to the reference core diameter. The reference core diameter may, for example, be a target or nominal core diameter, i.e., the target diameter during manufacturing of the HC-PCF, where the actual core diameter may deviate from this reference core diameter.

As can be seen in the figure, the radiation source RDS-C share many common parts or components with the radiation source RDS shown in Figure 8. Hence, same reference numerals are used to indicate the same parts or components. The main difference between the two radiation sources (RDS and RDS-C) lies in the additional the source control arrangement of the radiation source RDS-C. The pulse-chirp control unit CU may be configured to receive a laser pulse and subsequently apply either a fixed amount of dispersion or a tunable amount of dispersion to the laser pulse such that when exiting the pulse-chirp control unit CU, the temporal profile of the laser pulse is changed, e.g., stretched. How and to what extent the pulse temporal profile is changed may depend on many parameters, such as for example the bandwidth and wavelength of the laser pulse, the existing chirp (e.g., amount and sign) of the laser pulse, and amount and sign of the dispersion provided by the pulse-chirp control unit CU. In some preferred embodiments, the pulse-chirp control unit CU may be configured to provide a sufficient, linear and positive or negative chirp to the pump pulse such that upon leaving the pulse-chirp control unit CU, the pump pulse may always be positively or negatively chirped and thus temporally stretched to a desired pulse width.

The pulse-chirp control unit CU may be any type of pulse chirping (e.g., pulse stretching and/or compressing) device that is capable of applying a desired chirp to a laser pulse so as to obtain a temporally broadened pulse. For example, the above reference (by Gavin D. Reid and Klaas Wynne) describes several pulse stretching/compressing techniques commonly used in the field of ultrafast laser physics. In some embodiments, the pulse-chirp control unit CU may comprise a first type of pulse stretcher which comprises one or more (reflective or transmissive) gratings and optionally other optical elements (e.g., optical mirrors, optical lenses). In different embodiments, the pulse-chirp control unit CU may comprise a second type of pulse stretcher which comprises one or more prisms and optionally other optical elements (e.g., optical mirrors, optical lenses). In different embodiments, the pulse-chirp control unit CU may comprise a third type of pulse stretcher which comprises one or more gratings and one or more prisms, and optionally other optical elements (e.g., optical mirrors, optical lenses). Each of the above three types of pulse stretching device may provide a range of pulse chirp within which a desired amount of chirp can be selectively applicable to a laser pulse. In many cases, chirp tuning may be fully automatic. This may be achieved by mounting some components of the pulse-chirp control unit CU on one or more actuators (e.g., electric actuators) and by accurate calibration of the chirp across the moving range of the actuators. In other embodiments, the pulse-chirp control unit CU may comprise one or more highly dispersive elements (e.g., a block of highly dispersive glass) configured to provide a fixed amount of pulse chirp to a laser pulse.

In some embodiments, the pulse-chirp control unit CU may be a standalone device that may be placed in-between the pump radiation source PRS and the hollow core HC optical fiber OF (e.g., HC-PCF). In different embodiments, the pulse-chirp control unit CU may be integrated into the pump radiation source PRS so as to share a single enclosure. In other embodiments, the pump radiation source may be a chirp pulse amplification (CPA) system e.g., an Ytterbium CPA system, and the existing pulse compressor of the CPA system may be used as the pulse-chirp control unit CU.

Rather than being coupled directly into the hollow core HC optical fiber OF (e.g., HC-PCF) via the first transparent window TW1, the input radiation IRD emitted from the pump radiation source PRS may first be directed into the pulse-chirp control unit CU for pulse chirping (or pulse stretching). The temporally stretched pump pulse IRD-C may subsequently be coupled into the core of the optical fiber OF for generation of the broadband output radiation ORD. As described above, the pulse energy of the temporally stretched pump pulse IRD-C may be increased proportionally with the pulse stretching so as to maintain substantially the same pulse peak power. This may be useful in an initial optimization process (as described in detail below) where the pump pulse energy ramps up from a low energy level.

In some embodiments, the radiation source RDS-C may further comprise one or more optical measuring devices (not shown) configured to measure and/or monitor the broadband output radiation ORD. The one or more optical measuring devices may comprise for example a power measuring device and a spectrum measuring device configured to measure the average power and spectrum (or PSD) of the broadband output radiation, respectively. The optical measuring devices (e.g., the spectrum measuring device) may compare a measured data (e.g., a measured spectrum) with a target data (e.g., a target spectrum) and generate an error signal. Such an error signal may be used as a feedback signal for further optimization of the pulse-chirp control unit CU.

For example, in an embodiment, the error signal may be sent to a processing unit (not shown) of the radiation source RDS_C configured to process information received from components (e.g., optical measuring devices) of the source and execute (predefined and/or user input) tasks. In an embodiment, the processing unit may comprise the processor of the source control arrangement. In another embodiment, the processing unit may be communicatively coupled to the processor of the source control arrangement. In a different embodiment, the processing unit may be the processor of the source control arrangement.

Upon analyzing the error signal, the processing unit may generate and send a first control signal to the pulse-chirp control unit CU so as to change (e.g., increase) the chirp applied to the input radiation IRD (e.g., via movement of one or more actuators). The processing unit may optionally generate and send a second control signal to the pump radiation source PRS so as to change (e.g., increase) the pump pulse energy by the same proportion as the chirp. The same proportional changes made to the pump pulse chirp and pump pulse energy may keep the pulse peak power substantially the same while inducing changes in the broadband output radiation and thus the measured data. This may be particularly suitable for situations where the pump pulse energy has been automatically set to a different (e.g., lower) optimal value when a new fiber with a different (e.g., smaller) core diameter is used (e.g., as shown in Table 1). In the case where the pulse-chirp control unit CU is integrated within the pump radiation source PRS, both the first control signal and second control signal may be sent to the pump radiation source PRS.

The above-described optimization process may continue until the difference between the measured and target data is substantially small, e.g., smaller than a given threshold value. The difference may comprise a difference in the PSD of one or more predefined wavelengths (e.g., 800 nm) and/or the PSD averaged over a predefined wavelength range (e.g., 400 nm to 900 nm). The threshold PSD difference may be for example less than $\pm 15\%$, less than $\pm 10\%$, less than $\pm 5\%$, less than $\pm 1\%$. Where the pulse-chirp control unit is configured to provide a tunable chirp, the chirp may be in the range for example between -50000 $fs^2$ and 0 $fs^2$ and/or between 0 $fs^2$ and 50000 $fs^2$, between -40000 $fs^2$ and 0 $fs^2$ and/or between 0 $fs^2$ and 40000 $fs^2$, between -30000 $fs^2$ and 0 $fs^2$ and/or between 0 $fs^2$ and 30000 $fs^2$, or between -20000 $fs^2$ and 0 $fs^2$ and/or between 0 $fs^2$ and 20000 $fs^2$. Where the pulse-chirp control unit is configured to provide a fixed tunable chirp, the chirp may be for example 10000 $fs^2$, 20000 $fs^2$, 30000 $fs^2$, 40000 $fs^2$, or 50000 $fs^2$. The resultant pulse stretching ratio (i.e. the ratio of the pulse width after chirping over the pulse width before chirping) may be for example no less 100%, no less 75%, no less 50%, or no less than 25%. In some implementations, the pulsed pump radiation may comprise a centroid wavelength of between 1000 nm to 1100 nm, e.g., 1030 nm. In some implementations, the pulsed pump radiation may comprise a spectrum which supports a transform limited pulse width of between 100 fs and 500 fs.

Many HC-PCF based broadband radiation sources RDS-C (e.g., as shown in Figure 10) may suffer from lifetime issues due to for example fiber degradation and/or contamination. From time to time, either the existing optical fiber OF itself or the whole reservoir RSV including the fiber may need to be replaced. When a new optical fiber OF with a different core diameter has been installed in the radiation source RDS-C, the processing unit of the radiation source RDS-C may adjust the pressure of the working medium WM in accordance with the new core diameter so as to establish a dispersion environment required for generating a target broadband spectrum. The processing unit may obtain a different pressure value for example by referencing a predefined look-up table which contains the optimal gas pressures for a range of core diameters. Subsequently, the processing unit may determine whether the pump pulse chirp needs to be adjusted.

In an embodiment, the pump pulse energy may be fixed or maintained at a higher level that is optimal for generating a target spectrum from the upper-end of a manufacturing range (e.g., a range covering observed or expected variation from a nominal core diameter) for the core diameter (e.g., 33 $\mu$m for the above range of 27 $\mu$m to 33 $\mu$m). In such a case, the core diameter of a new fiber to be installed in the broadband radiation source RDS-C would either be the same as or smaller than the upper-end core diameter. For the upper-end core diameter, the chirp of the pulse-chirp control unit CU may be set to or substantially close to zero, which means the pump pulse is or substantially close to a transform limited pulse. When a new fiber with a smaller core diameter is used, the maintained pump pulse energy may be no longer optimal or too high for generating the target broadband spectrum, and the processing unit may therefore command the pulse-chirp control unit CU to apply a suitable amount of chirp so as to temporally broaden the pump pulse. The amount of chirp may be predetermined through numerical simulations. Optionally or in addition, the pulse-chirp control unit CU may allow for fine tuning of the chirp based on the feedback from one or more optical measuring devices (as described above). The purpose of the fine-tuning of the chirp may be to reduce or minimize the difference between the measured output spectrum (e.g. the PSD level) and the target spectrum.

In an embodiment, the radiation source may comprise a memory device which carries the information of the aforementioned look-up table and can be read by the processing unit. The information in the look up table may be e.g. the required gas pressure, pump pulse energy and pump pulse chirp according to the core diameter of the fiber installed in the reservoir RSV. These parameters may be precalculated from simulations or predetermined from experiments. Upon obtaining the parameters, the processing unit may send control signals respectively to different components/units of the radiation source RDS, e.g., the pulse chirp control unit CU, the working medium control unit.

Table 2 below shows multiple exemplary parameter sets for a HC-PCF with a nominal core diameter of 30 $\mu$m fiber and a manufacturing tolerance range of 27 $\mu$m - 33 $\mu$m. As can be seen in the table, when a fiber with a smaller core diameter (e.g., 27 $\mu$m) is used to replace a fiber with a larger core diameter (e.g., 33 $\mu$m), the gas pressure may be increased from a lower level (e.g., 21.0 bar) to a higher level (e.g., 32.1 bar) to maintain substantially the same dispersion environment. A positive or negative chirp (25000 $fs^2$) can then be applied to the pump pulse so as to temporally broaden the pulse width (e.g., from 250 fs to 372 fs). In the meantime, the pump pulse energy is maintained (e.g., at 6.4 $\mu$J) for all the core diameters of the manufacturing tolerance range.

Table 2

| Fiber core diameter ($\mu$m) | Working medium pressure (bar) | Relative pump pulse energy (%) | Pump pulse width (fs) | Absolute chirp or GDD ($fs^2$) |
|---|---|---|---|---|
| 27 | 32.1 | 67 | 372 | 25000 |

(continued)

| Fiber core diameter (μm) | Working medium pressure (bar) | Relative pump pulse energy (%) | Pump pulse width (fs) | Absolute chirp or GDD (fs²) |
|---|---|---|---|---|
| 28 | 29.8 | 73 | 340 | 21000 |
| 29 | 27.6 | 78 | 320 | 18000 |
| 30 | 25.7 | 83 | 302 | 15000 |
| 31 | 24.0 | 91 | 286 | 12500 |
| 32 | 22.4 | 94 | 267 | 8500 |
| 33 | 21.0 | 100 | 250 | 0 |

Figure 11 is a plot of point spread power spectral density (PSD) against wavelength λ describing a different simulation of three spectra of the broadband output radiation. Spectrum C1-UC corresponds to a baseline situation using an initial core diameter of 30 μm and an initial pump pulse energy of $E_{p,initial}$. Spectrum C2-UC corresponds to a situation where the fiber is replaced with one having a core diameter of 27 μm, and the known energy-compensation is used to compensate, resulting in a new pump pulse energy 81% × $E_{p,initial}$. With the energy-compensation technique, the pump pulse energy would need to be reduced from the initial pulse energy level $E_{p,initial}$ to 81% × $E_{p,initial}$ (e.g., to have a similar blue edge), which results in a significant change in the nominal PSD e.g., in the range between 400 nm to 900 nm. By comparison, spectrum C2-C corresponds also to a situation where the fiber is replaced with one having a core diameter of 27 μm, but where an additional chirp of about 10000 fs² has been applied to the pump pulse with the initial energy level $E_{p,initial}$ in accordance with the concepts disclosed herein. As can be seen, a significantly better matching of the absolute PSD level (between C1-UC and C2-C) can be achieved.

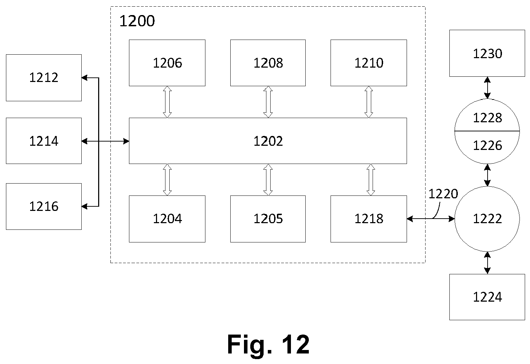

Figure 12 is a block diagram that illustrates a computer system 1400 that may assist in implementing the methods and flows disclosed herein. Computer system 1400 includes a bus 1402 or other communication mechanism for communicating information, and a processor 1204 (or multiple processors 1204 and 1205) coupled with bus 1202 for processing information. Computer system 1200 also includes a main memory 1206, such as a random access memory (RAM) or other dynamic storage device, coupled to bus 1202 for storing information and instructions to be executed by processor 1204. Main memory 1206 also may be used for storing temporary variables or other intermediate information during execution of instructions to be executed by processor 1204. Computer system 1200 further includes a read only memory (ROM) 1208 or other static storage device coupled to bus 1202 for storing static information and instructions for processor 1204. A storage device 1210, such as a magnetic disk or optical disk, is provided and coupled to bus 1202 for storing information and instructions.

Computer system 1200 may be coupled via bus 1202 to a display 1212, such as a cathode ray tube (CRT) or flat panel or touch panel display for displaying information to a computer user. An input device 1214, including alphanumeric and other keys, is coupled to bus 1202 for communicating information and command selections to processor 1204. Another type of user input device is cursor control 1214, such as a mouse, a trackball, or cursor direction keys for communicating direction information and command selections to processor 1204 and for controlling cursor movement on display 1212. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1200 in response to processor 1204 executing one or more sequences of one or more instructions contained in main memory 1206. Such instructions may be read into main memory 1206 from another computer-readable medium, such as storage device 1210. Execution of the sequences of instructions contained in main memory 1206 causes processor 1204 to perform the process steps described herein. One or more processors in a multi-processing arrangement may also be employed to execute the sequences of instructions contained in main memory 1206. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1204 for execution. Such a medium may take many forms, including but not limited to, non-volatile media, volatile media, and transmission media. Non-volatile media include, for example, optical or magnetic disks, such as storage device 1210. Volatile media include dynamic memory, such as main memory 1206. Transmission media include coaxial cables, copper wire and fiber optics, including the wires that comprise bus 1202. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1204 for execution. For example, the instructions may initially be borne on a magnetic disk of a remote computer. The remote computer can load the instructions into its dynamic memory and send the instructions over a telephone line using a modem. A modem local to computer system 1200 can receive the data on the telephone line and use an infrared transmitter to convert the data to an infrared signal. An infrared detector coupled to bus 1202 can receive the data carried in the infrared signal and place the data on bus 1202. Bus 1202 carries the data to main memory 1206, from which processor 1204 retrieves and executes the instructions. The instructions received by main memory 1206 may optionally be stored on storage device 1210 either before or after execution by processor 1204.

Computer system 1200 also preferably includes a communication interface 1218 coupled to bus 1202. Communication interface 1218 provides a two-way data communication coupling to a network link 1220 that is connected to a local network 1222. For example, communication interface 1218 may be an integrated services digital network (ISDN) card or a modem to provide a data communication connection to a corresponding type of telephone line. As another example, communication interface 1218 may be a local area network (LAN) card to provide a data communication connection to a compatible LAN. Wireless links may also be implemented. In any such implementation, communication interface 1218 sends and receives electrical, electromagnetic or optical signals that carry digital data streams representing various types of information.

Network link 1220 typically provides data communication through one or more networks to other data devices. For example, network link 1220 may provide a connection through local network 1222 to a host computer 1224 or to data equipment operated by an Internet Service Provider (ISP) 1226. ISP 1226 in turn provides data communication services through the worldwide packet data communication network, now commonly referred to as the "Internet" 1228. Local network 1222 and Internet 1228 both use electrical, electromagnetic or optical signals that carry digital data streams. The signals through the various networks and the signals on network link 1220 and through communication interface 1218, which carry the digital data to and from computer system 1200, are exemplary forms of carrier waves transporting the information.

Computer system 1200 may send messages and receive data, including program code, through the network(s), network link 1220, and communication interface 1218. In the Internet example, a server 1230 might transmit a requested code for an application program through Internet 1228, ISP 1226, local network 1222 and communication interface 1218. One such downloaded application may provide for one or more of the techniques described herein, for example. The received code may be executed by processor 1204 as it is received, and/or stored in storage device 1210, or other non-volatile storage for later execution. In this manner, computer system 1200 may obtain application code in the form of a carrier wave.

Additional embodiments have been disclosed in the subsequent list of numbered clauses:

1. A source control arrangement for a radiation source comprising a hollow-core photonic crystal fiber (HC-PCF), the HC-PCF comprising a hollow core with a core diameter, the source control arrangement comprising:

at least one processor; and
a pulse chirping arrangement configured to controllably chirp pulsed pump radiation so as to output chirped pulsed pump radiation for exciting a working medium comprised within the hollow core of the fiber at a pressure; wherein said processor is operable to configure source parameters of the radiation source, said source parameters including one or both of said pressure and a pulse chirp parameter, such that the chirped pulsed pump radiation undergoes a spectral broadening process within the HC-PCF, thereby generating an output radiation having a predefined spectrum for a reference core diameter of said HC-PCF, so as to compensate for variation in said core diameter with respect to the reference core diameter.

2. A source control arrangement as defined in clause 1, wherein the at least one processor is arranged to configure said source parameters such that the spectral broadening process is dominated by a modulation instability process.

3. A source control arrangement as defined in any preceding clause, wherein the at least one processor is arranged to configure said source parameters such that, while propagating through said hollow core, a pulse duration of the chirped pulsed pump radiation is maintained to be always broader than 75% of an initial pulse duration of the chirped pulsed pump radiation upon entering the hollow core.

4. A source control arrangement as defined in any preceding clause, wherein the at least one processor is configured to vary at least the pressure and/or the pulse chirp parameter so as to compensate for a change in the spectrum of said output radiation with respect to said predefined spectrum which results from a variation in the core diameter with respect to said reference core diameter, so as to substantially maintain said predefined spectrum.

5. A source control arrangement as defined in clause 4, operable such that the change in the spectrum with respect to said predefined spectrum comprises a change in power spectral density (PSD) at one or more wavelengths of a wavelength range.

6. A source control arrangement as defined in clause 4, operable such that the change in the spectrum with respect to said predefined spectrum comprises a change in power spectral density (PSD) averaged over a wavelength range.

7. A source control arrangement as defined in clause 5 or 6, operable such that the wavelength range is between 400 nm and 900 nm.

8. A source control arrangement as defined in any of clauses 4 to 6, wherein after compensation, the residual change in the PSD is less than 15%.

9. A source control arrangement as defined in any of clauses 5 to 7, wherein after compensation, the residual change in the PSD is less than 10%.

10. A source control arrangement as defined in any of clauses 5 to 7, wherein after compensation, the residual change in the PSD is less than 5%.

11. A source control arrangement as defined in any preceding clause, wherein the pulse chirping arrangement is configured such that the pulse chirp parameter is tunable in a range of between 0 $fs^2$ and 50000 $fs^2$ and/or between 0 $fs^2$ and -50000 $fs^2$.

12. A source control arrangement as defined in any of the clauses 1 to 10, wherein the pulse chirping arrangement is configured such that the pulse chirp parameter is tunable in a range of between 0 $fs^2$ and 40000 $fs^2$ and/or between 0 $fs^2$ and -40000 $fs^2$.

13. A source control arrangement as defined in any of the clauses 1 to 10, wherein the pulse chirping arrangement is configured such that the pulse chirp parameter is tunable in a range of between 0 $fs^2$ and 30000 $fs^2$ and/or between 0 $fs^2$ and -30000 $fs^2$.

14. A source control arrangement as defined in any of the clauses 1 to 10, wherein the pulse chirping arrangement is configured such that the pulse chirp parameter is tunable in a range of between 0 $fs^2$ and 20000 $fs^2$ and/or between 0 $fs^2$ and -20000 $fs^2$.

15. A source control arrangement as defined in any preceding clause, wherein the pulse chirping arrangement is configured such that the pulse chirp parameter is fixed at a value between -40000 $fs^2$ and 40000 $fs^2$.

16. A source control arrangement as defined in any of the clauses 1 to 14, wherein the pulse chirping arrangement is configured such that the pulse chirp parameter is fixed at a value between -30000$^2$ and 30000 $fs^2$.

17. A source control arrangement as defined in any of the clauses 1 to 14, wherein the pulse chirping arrangement is configured such that the pulse chirp parameter is fixed at a value between -20000 $fs^2$ and 20000 $fs^2$.

18. A radiation source, comprising:

the source control arrangement of any preceding clause; and
a hollow-core photonic crystal fiber (HC-PCF), the hollow-core photonic crystal fiber (HC-PCF) comprising a hollow core with said core diameter.

19. A radiation source as defined in clause 18, further comprising a pulsed pump radiation source arranged to produce the pulsed pump radiation and a working medium for filling the hollow core of the HC-PCF; wherein the source parameters further comprise parameters of the pulsed pump radiation and working medium.

20. A radiation source as defined in clause 19, wherein the pulsed pump radiation comprises a centroid wavelength of between 1000 nm to 1100 nm.

21. A radiation source as defined in clause 19 or 20, wherein the pulsed pump radiation comprises a spectrum which supports a transform limited pulse width of between 100 fs and 500 fs.

22. A radiation source as defined in any of clauses 19 to 21, wherein the pulse chirping arrangement is comprised within the pulsed pump radiation source.

23. A radiation source as defined in any of clauses 19 to 22, wherein the working medium comprises at least one of: a noble gas and a molecular gas.

24. A radiation source as defined in any of clauses 19 to 23, wherein the working medium is configured to produce anomalous dispersion in the hollow core of the HC-PCF.

25. A radiation source as defined in any of clauses 18 to 24, wherein said output radiation comprises at least wavelengths between 500 nm and 900 nm.

26. A metrology device comprising a radiation source as defined in any of clauses 18 to 25.

27. A metrology device as defined in clause 26, comprising a scatterometer metrology apparatus, a level sensor or an alignment sensor.

28. A lithographic apparatus comprising a source control arrangement as defined in any of clauses 1 to 17, or comprising a radiation source as defined in any of clauses 18 to 25, or comprising a metrology device as defined in clause 26 or 27.

29. A lithographic cell comprising a lithographic apparatus as defined in clause 28 and/or comprising a source control arrangement as defined in any of clauses 1 to 17, or comprising a radiation source as defined in any of clauses 18 to 25, or comprising a metrology device as defined in clause 26 or 27.

30. A method of controlling a radiation source comprising a hollow-core photonic crystal fiber (HC-PCF), the HC-PCF comprising a hollow core with a core diameter, the method comprising:

controllably chirping pulsed pump radiation so as to output chirped pulsed pump radiation for exciting a working medium comprised within the hollow core of the fiber at a pressure; and
configuring source parameters of the radiation source, said source parameters including one or both of said pressure and a pulse chirp parameter, such that the chirped pulsed pump radiation undergoes a spectral broadening process within the HC-PCF, thereby generating an output radiation having a predefined spectrum for a reference core diameter of said HC-PCF, so as to compensate for variation in said core diameter with respect to the reference core diameter.

31. A method as defined in clause 30, wherein the source parameters are configured such that the spectral broadening process is dominated by a modulation instability process.

32. A method as defined in clause 30 or 31, wherein the source parameters are configured such that, while propagating through the hollow core of the fiber, a pulse duration of the chirped pulsed pump radiation is maintained to be always broader than 75% of an initial pulse duration of the chirped pulsed pump radiation upon entering the hollow core of the fiber.

33. A method as defined in any of clauses 30 to 32, further comprising varying the pressure and/or the pulse chirp parameter so as to compensate for a change in the spectrum of said output radiation with respect to the predefined spectrum which results from a variation in the core diameter with respect the reference core diameter, so as to substantially maintain said predefined spectrum.

34. A method as defined in clause 33, wherein the step of varying the pressure and/or the pulse chirp parameter comprises varying the pressure to establish a predefined dispersion environment for the spectral broadening process before varying the pulse chirping.

35. A method as defined in clause 34, further comprising

measuring the change in the spectrum of said output radiation;
varying the pulse chirp parameter until the residual change in the spectrum after compensation is below a threshold level.

36. A method as defined in clause 35, further comprising generating an error signal according to the measured change and varying the pulse chirp parameter according to the error signal.

37. A method as defined in any of clauses 33 to 36, wherein the change in the spectrum with respect to the predefined spectrum comprises a change in power spectral density (PSD) at one or more wavelengths of a wavelength range.

38. A method as defined in any of clauses 33 to 36, wherein the change in the spectrum with respect to the predefined spectrum comprises a change in power spectral density (PSD) averaged over a wavelength range.

39. A method as defined in clause 37 or 38, wherein the wavelength range is between 400 nm and 900 nm.

40. A method as defined in any of clauses 35 to 39, wherein the threshold level for the change in the PSD is 15%.

41. A method as defined in any of clauses 35 to 39, wherein the threshold level for the change in the PSD is 10%.

42. A method as defined in any of clauses 35 to 39, wherein the threshold level for the change in the PSD is less than 5%.

43. A method as defined in any of clauses 30 to 42, comprising:

installing a new HC-PCF into the radiation source; and
performing said configuring step for the new HC-PCF.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A source control arrangement for a radiation source comprising a hollow-core photonic crystal fiber (HC-PCF), the HC-PCF comprising a hollow core with a core diameter, the source control arrangement comprising:

   at least one processor; and
   a pulse chirping arrangement configured to controllably chirp pulsed pump radiation so as to output chirped pulsed pump radiation for exciting a working medium comprised within the hollow core of the fiber at a pressure; wherein said processor is operable to configure source parameters of the radiation source, said source parameters including one or both of said pressure and a pulse chirp parameter, such that the chirped pulsed pump radiation undergoes a spectral broadening process within the HC-PCF, thereby generating an output radiation having a predefined spectrum for a reference core diameter of said HC-PCF, so as to compensate for variation in said core diameter with respect to the reference core diameter.

2. A source control arrangement as claimed in claim 1, wherein the at least one processor is arranged to configure said source parameters such that the spectral broadening process is dominated by a modulation instability process.

3. A source control arrangement as claimed in any preceding claim, wherein the at least one processor is arranged to configure said source parameters such that, while propagating through said hollow core, a pulse duration of the chirped pulsed pump radiation is maintained to be always broader than 75% of an initial pulse duration of the chirped pulsed pump radiation upon entering the hollow core.

4. A source control arrangement as claimed in any preceding claim, wherein the at least one processor is configured to vary at least the pressure and/or the pulse chirp parameter so as to compensate for a change in the spectrum of said output radiation with respect to said predefined spectrum which results from a variation in the core diameter with respect to said reference core diameter, so as to substantially maintain said predefined spectrum.

5. A source control arrangement as claimed in claim 4, operable such that the change in the spectrum with respect to said predefined spectrum comprises a change in power spectral density (PSD) at one or more wavelengths of a wavelength range.

6. A source control arrangement as claimed in claim 4, operable such that the change in the spectrum with respect to said predefined spectrum comprises a change in power spectral density (PSD) averaged over a wavelength range.

7. A source control arrangement as claimed in claim 5 or 6, operable such that the wavelength range is between 400 nm and 900 nm.

8. A source control arrangement as claimed in any of claims 4 to 6, wherein after compensation, the residual change in the PSD is less than 15%.

9. A source control arrangement as claimed in any preceding claim, wherein the pulse chirping arrangement is configured such that the pulse chirp parameter is tunable in a range of between $0 \text{ fs}^2$ and $50000 \text{ fs}^2$ and/or between $0 \text{ fs}^2$ and $-50000 \text{ fs}^2$.

10. A radiation source, comprising:

    the source control arrangement of any preceding claim; and
    a hollow-core photonic crystal fiber (HC-PCF), the hollow-core photonic crystal fiber (HC-PCF) comprising a hollow core with said core diameter.

11. A radiation source as claimed in claim 10, further comprising a pulsed pump radiation source arranged to produce the pulsed pump radiation and a working medium for filling the hollow core of the HC-PCF; wherein the source parameters further comprise parameters of the pulsed pump radiation and working medium.

12. A radiation source as claimed in claim 11, wherein the pulsed pump radiation comprises a spectrum which supports a transform limited pulse width of between 100 fs and 500 fs.

13. A radiation source as claimed in any of claims 11 or 12, wherein the pulse chirping arrangement is comprised within the pulsed pump radiation source.

14. A metrology device comprising a radiation source as claimed in any of claims 10 to 13.

15. A method of controlling a radiation source comprising a hollow-core photonic crystal fiber (HC-PCF), the HC-PCF comprising a hollow core with a core diameter, the method comprising:

controllably chirping pulsed pump radiation so as to output chirped pulsed pump radiation for exciting a working medium comprised within the hollow core of the fiber at a pressure; and
configuring source parameters of the radiation source, said source parameters including one or both of said pressure and a pulse chirp parameter, such that the chirped pulsed pump radiation undergoes a spectral broadening process within the HC-PCF, thereby generating an output radiation having a predefined spectrum for a reference core diameter of said HC-PCF, so as to compensate for variation in said core diameter with respect to the reference core diameter.

**Fig. 1**

**Fig. 2**

LA

SC1

SC3

MT

CL

-1  0  +1

SC2

**Fig. 3**

SM1

2

4

PU

Z

X

W

I

6

λ

Z

8

X

**Fig. 4**

Fig. 5

Fig. 6

Fig. 7

Fig. 8

Fig. 9

**Fig. 10**

**Fig. 11**

**Fig. 12**

Europäisches
Patentamt

European
Patent Office

Office européen
des brevets

## EUROPEAN SEARCH REPORT

**Application Number**

EP 21 20 5790

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | "METHODS AND APPARATUS FOR PROVIDING A BROADBAND LIGHT SOURCE", RESEARCH DISCLOSURE, KENNETH MASON PUBLICATIONS, HAMPSHIRE, UK, GB, vol. 682, no. 59, 19 January 2021 (2021-01-19), XP007149124, ISSN: 0374-4353 [retrieved on 2021-01-19] | 1-4,6-15 | INV. G02F1/365 G02B6/02 ADD. G02F1/35 G03F9/70 |
| Y | * paragraphs [0008], [0009], [0012], [0021], [0036], [0100], [0103] – [0104], [0107], [0127], [0129] * | 5 | |
| Y | "HOLLOW-CORE OPTICAL FIBER BASED RADIATION SOURCE", RESEARCH DISCLOSURE, KENNETH MASON PUBLICATIONS, HAMPSHIRE, UK, GB , vol. 686, no. 26 10 May 2021 (2021-05-10), XP007149447, ISSN: 0374-4353 Retrieved from the Internet: URL:ftp://ftppddoc/RDData686_EPO.zip Pdf/686026.pdf * figure 14B * * paragraph [0009] * | 5 | |

TECHNICAL FIELDS SEARCHED (IPC)

G02F
G02B
G03F

The present search report has been drawn up for all claims

| Place of search | Date of completion of the search | Examiner |
|---|---|---|
| The Hague | 7 April 2022 | Topak, Eray |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
........................................................................................
& : member of the same patent family, corresponding
   document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B

- US 13533110 B
- US 13891410 B
- WO 2011012624 A
- US 20160161863 A
- US 20160370717 A1
- US 7265364 B
- US 7646471 B
- US 2010233600 A1
- WO 2016102127 A1
- US 6961116 B
- US 2015261097 A1
- US 2004015085 A1
- WO 2017032454 A1
- WO 2018127266 A1
- US 9160137 B1

**Non-patent literature cited in the description**

- Ultrafast Laser Technology and Spectroscopy. **GAVIN D. REID ; KLAAS WYNNE.** Encyclopedia of Analytical Chemistry. John Wiley & Sons Ltd, 2000, 13644-13670